# FASCICULE DE BREVET EUROPEEN

(11) **EP 3 502 049 B1**
(45) Date de publication et mention de la délivrance du brevet: **18.05.2022**
(21) Numéro de dépôt: 19405001.9
(22) Date de dépôt: 03.01.2019
(51) Int. Cl.: B82Y 10/00, B82Y 40/00, H01L 29/66, H01L 29/76, H01L 29/775, H01L 29/06, H01L 29/08, H01L 29/10

(54) **PROCEDE DE REALISATION D'UN DISPOSITIF SEMI-CONDUCTEUR COMPRENANT UNE OU PLUSIEURS NANOSTRUCTURES**
HERSTELLUNGSVERFAHREN EINER HALBLEITERVORRICHTUNG, DIE EINE ODER MEHRERE NANOSTRUKTUREN UMFASST
METHOD FOR MANUFACTURING A SEMICONDUCTOR DEVICE COMPRISING ONE OR MORE NANOSTRUCTURES

(30) Priorité: 22.12.2017 US 201715852050
(43) Date de publication de la demande: 26.06.2019
(73) Titulaire: Commissariat à l'énergie atomique et aux énergies alternatives, 75015 Paris (FR); International Business Machines Corporation, Armonk, NY 10504-1722 (US)
(72) Inventeur: Reboh, Shay, 38054 Grenoble Cedex 09 (FR); Cheng, Kangguo, Schenectady, NY 12303 (US); Coquand, Rémi, 73800 LES Marches (FR); Loubet, Nicolas, Guilderland, NY 12084 (US)
(74) Mandataire: Brevalex

(56) Documents cités:
- US-A1- 2009 090 934
- US-A1- 2011 133 162
- US-A1- 2016 315 167
- US-A1- 2017 040 321
- US-B1- 9 484 406
- US-B1- 9 825 143

## Description

### DOMAINE TECHNIQUE ET ART ANTÉRIEUR

L'invention concerne la réalisation de dispositifs semi-conducteurs comprenant une ou plusieurs nanostructures. L'invention s'applique notamment à la réalisation de nanostructures au sein de dispositifs semi-conducteurs tels que des transistors de type FET, avantageusement de type GAA-FET (« Gate-All-Around Field Effect Transistor », ou transistor à effet de champ à grille enrobante), ou de transistors de type SET (« Single-Electron Transistor », ou transistor à électron unique ou transistor mono-électronique).

Plusieurs approches sont connues pour réaliser des nanostructures, notamment des nanostructures dites organisées.

Tout d'abord, il existe des procédés de type « Top-down » qui proposent de réaliser les nanostructures via la mise en œuvre d'étapes de dépôt d'un ou plusieurs matériaux, de lithographie selon le motif souhaité pour les nanostructures, puis de gravure pour obtenir les nanostructures souhaitées au sein des couches de matériaux déposées. Les dimensions et densités des nanostructures pouvant être obtenues avec cette approche sont toutefois limitées du fait des limites de précision pouvant être atteintes par la lithographie. Ainsi, la lithographie n'est pas adaptée pour la réalisation de nanostructures de dimensions inférieures à environ 10 nm. De plus, la lithographie n'est également pas adaptée pour réaliser des structures organisées verticalement, c'est-à-dire le long d'une surface verticale. De tels procédés sont, par exemple, décrits dans US-9,825,143, US-2016/315167 et US-9,484,406. Z

Il existe également des procédés de type « Bottom-up » qui proposent de réaliser des nanostructures via une disposition individuelle contrôlée des atomes ou molécules de matériaux destinés à former les nanostructures les unes au-dessus des autres. De tels procédés sont toutefois limités à la réalisation individuelle de très petites nanostructures et ne sont pas adaptés pour une réalisation industrielle de nanostructures.

### EXPOSÉ DE L'INVENTION

Un but de la présente invention est de proposer un nouveau procédé de réalisation d'un dispositif semi-conducteur comprenant au moins une ou plusieurs nanostructures organisées, permettant de contrôler verticalement et horizontalement le positionnement et les dimensions de la ou des nanostructures, et qui soit compatible avec la réalisation de nanostructure(s) de très petites dimensions, par exemple inférieures à environ 10 nm.

Pour cela, la présente invention propose un procédé de réalisation tel que défini par la revendication 1

Ce procédé met en œuvre un phénomène de migration de surface d'atomes de semi-conducteur pour réaliser la ou les nanostructures, cette migration de surface des atomes de semi-conducteur étant déclenchée par un apport d'énergie suffisant à ces atomes. La nanostructure se forme de manière auto-organisée du fait que la partie de la première portion, formant par exemple un bord et/ou une extrémité de la première portion, comporte une surface libre, c'est-à-dire non recouverte par un autre élément et notamment non recouverte par la deuxième portion, qui forme la surface au niveau de laquelle les atomes du deuxième semi-conducteur migrent pour former la nanostructure. L'épaisseur de la nanostructure est prédéfinie automatiquement par le choix de l'épaisseur de la première portion réalisée. L'épaisseur de la première portion correspond à la dimension de la première portion qui est sensiblement perpendiculaire à une interface entre les première et deuxième portions.

En outre, la profondeur de la nanostructure (dimension sensiblement perpendiculaire à la surface de la première portion qui est non recouverte par la deuxième portion et depuis laquelle se forme la nanostructure) réalisée peut dépendre des paramètres de mise en œuvre du traitement thermique, ou recuit, notamment de la température et de la durée pendant laquelle le traitement thermique est réalisé. Dans certains cas, la profondeur de la nanostructure peut être égale à l'épaisseur de la nanostructure. Les caractéristiques de la nanostructure réalisée dépendent de l'apport d'énergie reçu. Il est ainsi possible de choisir ces paramètres tels que la profondeur de la nanostructure réalisée soit très faible, par exemple comprise entre environ 1 nm et 10 nm. Enfin, les autres dimensions de la nanostructure peuvent être définies par les dimensions de la partie de la première portion au niveau de laquelle et/ou dans laquelle la nanostructure est réalisée.

Toutes les dimensions ainsi que le positionnement de la nanostructure sont donc bien contrôlés indirectement via les dimensions et le positionnement de la première portion ainsi que via les paramètres de mise en œuvre du traitement thermique engendrant la migration de surface des atomes du deuxième semi-conducteur de la deuxième portion.

Le procédé peut être tel que :
- le premier semi-conducteur comporte du Si, et/ou,
- le deuxième semi-conducteur comporte du Ge, et/ou,
- la température du traitement thermique est comprise entre environ 750°C et 850°C, et/ou
- le traitement thermique est mis en œuvre dans une atmosphère contenant de l'hydrogène, par exemple une atmosphère de dihydrogène pur ou d'un mélange de dihydrogène et d'un ou plusieurs autres gaz (N₂, He, etc.).

La présence d'hydrogène dans l'atmosphère lors de la migration de surface des atomes du deuxième semi-conducteur vers le premier semi-conducteur améliore la mobilité des atomes du deuxième semi-conducteur vers la partie de la première portion au niveau de laquelle la nanostructure se forme.

Lorsque le premier semi-conducteur correspond à du silicium et que le deuxième semi-conducteur correspond à du germanium ou du SiGe, un traitement thermique mis en œuvre à une température comprise entre environ 750°C et 850°C provoque au moins une migration de surface des atomes de germanium issus de la deuxième portion dans le silicium de la première portion, ce qui forme alors la nanostructure qui comporte du SiGe.

Le deuxième semi-conducteur peut comporter du SiGe ayant par exemple une concentration en germanium comprise entre environ 20 % et 80 %.

L'épaisseur de la première portion peut par exemple être comprise entre environ 4 nm et 20 nm.

Selon une configuration avantageuse, l'empilement peut comporter une alternance de plusieurs premières et deuxièmes portions, la mise en œuvre du traitement thermique pouvant dans ce cas engendrer au moins une migration de surface des atomes du deuxième semi-conducteur des deuxièmes portions vers des parties des premières portions présentant chacune au moins une surface libre, notamment non recouverte par les deuxièmes portions, et au niveau de chacune desquelles, ou dans chacune desquelles, se forme au moins une nanostructure comprenant au moins des atomes du deuxième semi-conducteur. Cette configuration avantageuse permet notamment la réalisation de nanostructures organisées selon une surface verticale et empilées les unes au-dessus des autres.

Dans ce cas, plusieurs des deuxièmes portions peuvent comporter des deuxièmes semi-conducteurs de compositions et/ou de concentrations atomiques différentes les unes des autres, formant des nanostructures comprenant des semi-conducteurs différents. Deux semi-conducteurs de compositions différentes correspondent à deux semi-conducteurs n'ayant pas les mêmes types d'atomes, c'est-à-dire correspondent à deux semi-conducteurs de natures différentes. Deux semi-conducteurs de concentrations atomiques différentes correspondent à deux semi-conducteurs ayant les mêmes types d'atomes mais en proportion différente l'un par rapport à l'autre.

De manière avantageuse, chaque deuxième portion peut comporter du SiGe ayant une concentration en germanium différente de celle du SiGe des autres deuxièmes portions.

Plusieurs des premières portions peuvent comporter des épaisseurs différentes les unes des autres, et/ou plusieurs des deuxièmes portions peuvent comporter des épaisseur différentes les unes des autres. Dans ce cas, les nanostructures obtenues comportent des épaisseurs différentes.

Dans un tel procédé, les nanostructures peuvent donc être formées aux extrémités de la ou des parties restantes de la ou des premières portions formant notamment le canal du dispositif semi-conducteur.

Le semi-conducteur des régions de source et de drain peut être du silicium dopé.

Le procédé peut comporter en outre, entre l'étape de gravure de l'empilement et l'étape de réalisation des régions de source et de drain, la mise en œuvre des étapes suivantes :
- gravure partielle de la partie restante de la deuxième portion depuis des extrémités de la partie restante de la deuxième portion révélées par la gravure de l'empilement, formant des cavités disposées au moins sous les espaceurs externes,
- réalisation d'espaceurs internes dans les cavités.

Les espaceurs internes peuvent être réalisés après les nanostructures.

Selon un exemple illustratif, le procédé peut comporter en outre, entre l'étape de traitement thermique et l'étape de réalisation des régions de source et de drain, la mise en œuvre d'une étape de suppression des nanostructures, les régions de source et de drain étant réalisée par épitaxie de semi-conducteur depuis au moins la portion restante de la première portion. Du fait que les dimensions et le positionnement des nanostructures sont bien contrôlés, la position des jonctions entre la ou les parties restantes de la ou des premières portions formant le canal et les régions de source et de drain est également bien contrôlée, notamment vis-à-vis de la grille factice, ce qui permet d'éviter un positionnement des régions de source et de drain dans des emplacements exposés lors de la gravure de la grille factice. Cela est particulièrement avantageux lorsque les régions de source et de drain comportent un matériau susceptible d'être gravé par l'agent de gravure utilisé lors de la suppression de la grille factice, comme par exemple du SiGe.

Selon un mode de réalisation particulier, le procédé peut être tel que :
- le procédé comporte en outre, entre l'étape de réalisation des régions de source et de drain et l'étape de suppression de la grille factice et de la partie restante de la deuxième portion, la mise en œuvre d'un dopage du semi-conducteur des régions de source et de drain, puis d'un recuit diffusant des dopants dans le semi-conducteur des régions de source et de drain, ou
- l'étape de réalisation des régions de source et de drain est mise en œuvre telle que le semi-conducteur des régions de source et de drain soit dopé.

Dans ce cas, la présence des nanostructures entre les régions de source et de drain et la partie restante de la ou des premières portions formant le canal du dispositif semi-conducteur peut assurer la non-diffusion des dopants dans le canal.

Le procédé ci-dessus en bien adapté à la réalisation d'un dispositif semi-conducteur correspondant à un transistor SET. En effet, avec ce procédé, la partie de la première portion vers laquelle migrent les atomes du deuxième semi-conducteur, et qui est destinée à former un îlot quantique du transistor SET, a avantageusement des dimensions (par exemple dimensions des côtés dans le cas d'une portion de forme sensiblement parallélépipédique) inférieures à environ 10 nm. Ce procédé a également pour avantage de former l'îlot quantique de manière auto-alignée vis-à-vis des autres éléments du transistor (notamment les barrières à blocage de Coulomb formées par les parties restantes de la première portion qui sont adjacente à la nanostructure, et les espaceurs).

Les procédés ci-dessus s'appliquent avantageusement à la réalisation de dispositifs semi-conducteurs correspondant à des transistors, par exemple de type GAA-FET ou SET, ou plus généralement à des transistors comprenant un ou plusieurs nanofils, ou bien encore à tous les dispositifs semi-conducteurs dans lesquels un confinement quantique peut être réalisé.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent une première partie des étapes d'un procédé de réalisation d'un dispositif semi-conducteur selon l'invention,
- la figure 5 présente la migration d'atomes des surfaces libres du deuxième semi-conducteur vers les surfaces libres du premier semi-conducteur,
- les figures 6 à 11 représentent les étapes d'un procédé de réalisation d'un dispositif semi-conducteur, objet de la présente invention, selon un mode de réalisation,
- la figure 12 représente une structure intermédiaire obtenue lors de la mise en œuvre d'un procédé de réalisation d'un dispositif semi-conducteur, objet de la présente invention, selon un autre mode de réalisation,
- les figures 13 et 14 représentent des structures intermédiaires obtenues lors de la mise en œuvre d'un procédé de réalisation d'un dispositif semi-conducteur selon un exemple non-revendiqué mais utile à la compréhension de l'invention,
- les figures 15 à 18 représentent une parties des étapes d'un procédé de réalisation d'un dispositif semi-conducteur selon un exemple non-revendiqué mais utile à la compréhension de l'invention.
- les figures 19 à 28 représentent les étapes d'un procédé de réalisation d'un dispositif semi-conducteur selon un exemple non-revendiqué mails utile Z à la compréhension de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

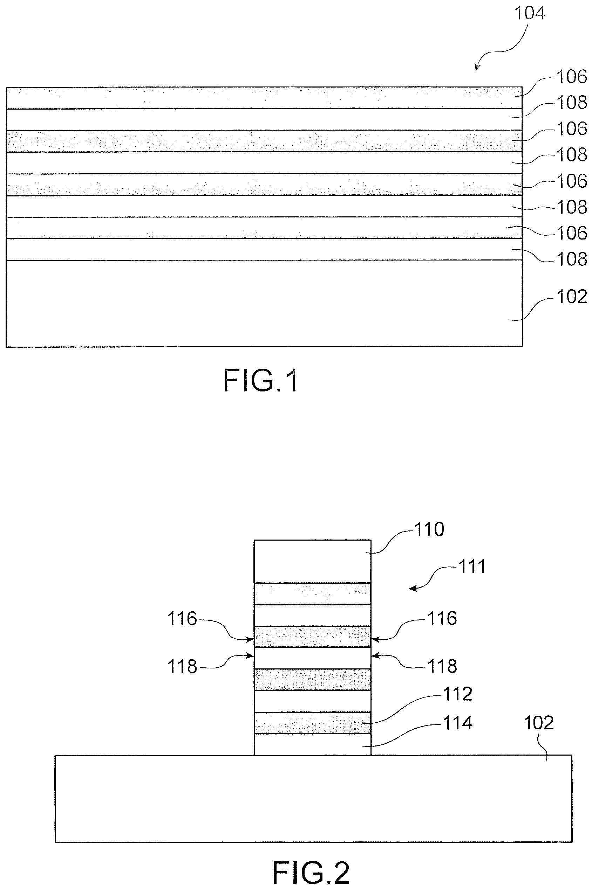

On se réfère tout d'abord aux figures 1 à 4 qui représentent les étapes d'un procédé de réalisation d'un dispositif semi-conducteur 200, représentant une première partie du procédé de l'invention.

Un empilement 104 de premières couches 106 comprenant un premier semi-conducteur et de deuxièmes couches 108 comprenant un deuxième semi-conducteur, différent du premier semi-conducteur, disposées de manière alternée les unes au-dessus des autres, est réalisé sur un substrat 102 (figure 1). Le substrat 102 correspond par exemple à un substrat de semi-conducteur tel qu'un substrat de silicium. Le substrat 102 est ici un substrat massif de type « bulk », mais il peut correspondre à un autre type de substrat, par exemple un substrat SOI (« Silicon On Insulator », ou silicium sur isolant) ou SiGeOI (« SiGe On Insulator », ou SiGe sur isolant).

Le nombre de premières couches 106 et de deuxièmes couches 108 est choisi notamment en fonction de la structure du dispositif semi-conducteur 200 à réaliser. Par exemple, lorsque le dispositif 200 correspond à un transistor comprenant un ou plusieurs nanofils, par exemple de type GAA-FET, le nombre de couches 106, 108 est choisi en fonction du nombre de nanofils à réaliser pour former le canal du transistor.

Les premières couches 106 sont destinées à former des premières portions du premier semi-conducteur sur et/ou dans lesquelles des nanostructures 100 sont réalisées, et les deuxièmes couches 108 sont destinées à former des deuxièmes portions du deuxième semi-conducteur servant à fournir des atomes du deuxième semi-conducteur pour former, par migration de surface contre et/ou dans des parties des premières portions, les nanostructures 100.

Selon une réalisation avantageuse, les premières couches 106 comportent du silicium et les deuxièmes couches 108 comportent du SiGe. Le SiGe des deuxièmes couches 108 peut avoir une concentration en germanium comprise entre environ 10 % et 80 %, et par exemple comprise entre environ 25 % et 50 %.

Plus généralement, les premier et deuxième semi-conducteurs des couches 106, 108, et donc également le semi-conducteur des nanostructures 100, correspondent à des semi-conducteurs de type III-V, c'est-à-dire comprenant un ou plusieurs éléments des colonnes III et V du tableau périodique de Mendeleïev.

Les premières couches 106 sont réalisées avec une épaisseur correspondant à celle souhaitée pour les premières portions et pour les nanostructures 100. Selon une réalisation avantageuse, les épaisseurs des premières et deuxièmes couches 106, 108 sont par exemple comprises entre environ 4 nm et 50 nm, et par exemple égales à 8 nm.

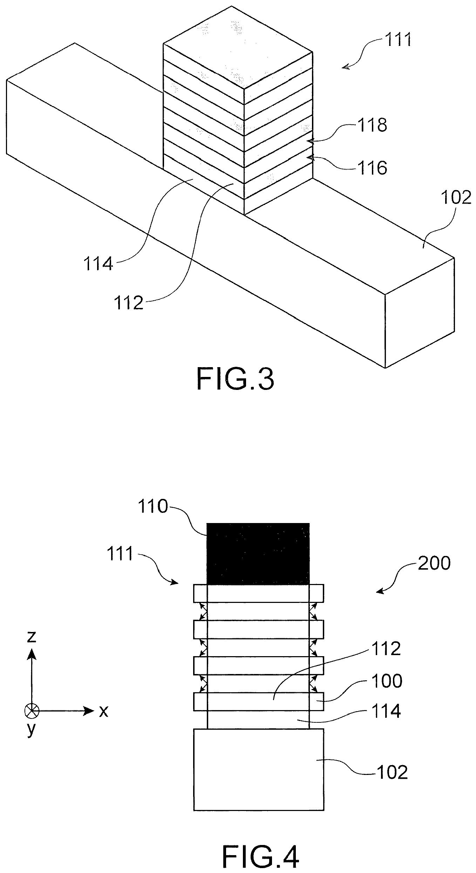

L'empilement 104 est gravé selon les dimensions souhaitées des premières et deuxièmes portions, via le dépôt d'un masque de gravure 110 conforme à ces dimensions, d'une lithographie de l'empilement 104 ainsi masqué et d'une gravure de l'empilement 104 afin de former un empilement 111 comprenant des portions restantes des premières et deuxièmes couches 106, 108. Les portions restantes des premières couches 106 forment des premières portions 112 comprenant le premier semi-conducteur et les portions restantes des deuxièmes couches 108 forment des deuxièmes portions 114 comprenant le deuxième semi-conducteur (figure 2). Cette gravure forme notamment des faces latérales 116 des premières portions 112 et des faces latérales 118 des deuxièmes portions 114, qui correspondent aux bords de ces portions 112, 114. La figure 3 correspond à une vue en perspective de l'empilement 111 des premières et deuxièmes portions 112, 114 obtenues, en l'absence du masque 110.

Suivant les dimensions des premières et deuxièmes portions 112, 114, l'empilement 111 peut former une structure de type « nano-dot » ou une structure de type nanofil ayant une forme longiligne dans un plan parallèle à l'interface entre l'empilement 111 et le substrat 102.

Selon l'invention, un traitement thermique de l'empilement 111 est ensuite mis en œuvre. L'énergie thermique apportée entraîne une migration de surface d'atomes du deuxième semi-conducteur depuis les deuxièmes portions 114 jusque vers les bords des premières portions 112, correspondant ici aux faces latérales 116, et formant les nanostructures 100 au niveau des faces latérales 116 des premières portions 112 (figure 4). Sur la figure 4, les flèches représentent symboliquement la migration de surface des atomes du deuxième semi-conducteur engendrée par le traitement thermique. Dans l'exemple de réalisation particulier décrit ici, une migration de surface du germanium présent dans le SiGe des deuxièmes portions 114 s'opère vers les faces latérales 116 pour former les nanostructures 100 composées de SiGe riche en germanium par rapport au semi-conducteur des premières portions 112.

La migration de surface se produit sur une très faible profondeur de matériau (dimension selon l'axe X représenté sur la figure 4) des bords des premières portions 112. Ainsi, la profondeur des nanostructures 100 réalisées est par exemple comprise entre environ 1 nm et 10 nm, voire comprise entre environ 1 nm et 5 nm.

Dans l'exemple de réalisation particulier décrit ici, ce traitement thermique est mis en œuvre à une température comprise entre environ 750°C et 1000°C, pendant une durée par exemple comprise entre environ 1 minute et 5 minutes. La température à laquelle le traitement thermique est mis en œuvre est choisie notamment en fonction de la nature du ou des atomes de semi-conducteur destinés à migrer, l'énergie thermique fournie par ce traitement thermique devant être suffisante pour engendrer cette migration de surface. En outre, dans cet exemple, le traitement thermique est mis en œuvre sous atmosphère d'hydrogène. Cette atmosphère d'hydrogène facilite la mobilité des atomes de germanium au niveau des faces latérales 116 des premières portions 112.

De manière générale, et suivant la nature des semi-conducteurs choisis, il est possible que la migration de surface s'opère depuis les premières portions 112 et/ou depuis les deuxièmes portions 114, vers des parties des premières portions 112 et/ou vers des parties des deuxièmes portions 114. Ainsi, les nanostructures 100 peuvent être formées du deuxième et/ou du premier semi-conducteurs et être disposées au niveau de parties des premières portions 112 et/ou des deuxièmes portions 114.

Dans ce procédé, les nanostructures 100 sont réalisées de manière auto-organisées car les formes, emplacements et dimensions de ces nanostructures 100 sont prédéfinis avant la mise en œuvre du traitement thermique formant les nanostructures 100. Ainsi, l'épaisseur (dimension selon l'axe Z représenté sur la figure 4 et perpendiculaire aux interfaces entre les premières portions 112 et les deuxièmes portions 114) des nanostructures 100 est définie et correspond à l'épaisseur des premières portions 112, et donc à l'épaisseur des premières couches 106. La largeur ou la longueur des nanostructures 100 (dimension selon l'axe Y représenté sur la figure 4) est définie par les dimensions initiales des premières portions 112 obtenues à l'issue de la gravure de l'empilement 104 de couches 106, 108. Enfin, la profondeur (dimension selon l'axe X représenté sur la figure 4) des nanostructures 100 est définie par les conditions (température de recuit, durée du recuit, atmosphère dans laquelle le recuit est mis en œuvre) dans lesquelles le recuit engendrant la migration de surface des espèces chimiques est mis en œuvre.

Dans la partie du procédé de l'invention décrit ci-dessus, toutes les premières portions 112 comportent le même premier semi-conducteur, et toutes les deuxièmes portions 114 comportent le même deuxième semi-conducteur. Ainsi, toutes les nanostructures 100 comportent le même semi-conducteur qui est formé d'atomes des premier et deuxième semi-conducteurs.

En variante, il est possible que les compositions et/ou concentrations relatives au sein des premier et deuxième semi-conducteurs soient différentes d'une première portion 112 à l'autre et/ou d'une deuxième portion 114 à l'autre. Dans ce cas, les compositions et/ou concentrations atomiques des semi-conducteurs des nanostructures 100 réalisées sont différentes suivant leur disposition au sein de l'empilement, du fait que ces compositions et/ou concentrations atomiques des semi-conducteurs des nanostructures dépendent de la composition et/ou concentration atomiques des semi-conducteurs adjacents à la portion sur et/ou dans laquelle les nanostructures 100 sont réalisées. Ces différences de composition et/ou de concentration dans les semi-conducteurs au sein de l'empilement 111 peuvent être créées par la mise en œuvre de techniques de dépôt appropriées telles que le PVD (dépôt physique en phase vapeur), le CVD (dépôt chimique en phase vapeur), le MBE (épitaxie par jet moléculaire), etc.

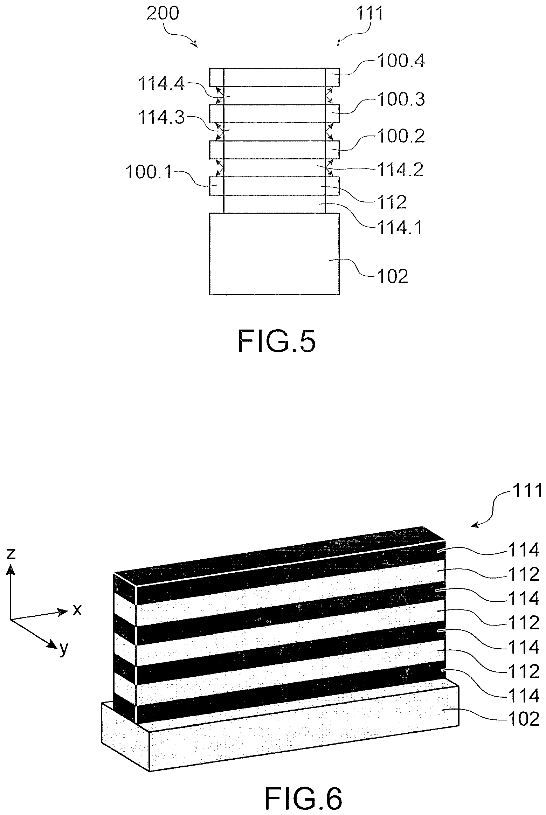

Par exemple, la composition des matériaux déposés pour former l'empilement 111 (issu de l'empilement 104) peut être modifiée graduellement depuis les portions basses (celles du côté du substrat 102) jusque vers les portions hautes. Un tel exemple de réalisation est représenté sur la figure 5 sur laquelle les semi-conducteurs (SiGe) des quatre deuxièmes portions 114, référencées 114.1 - 114.4, ont des compositions différentes, et plus particulièrement des concentrations en germanium différentes d'une deuxième portion 114 à l'autre. Ces compositions différentes se retrouvent dans les deuxièmes couches 108 ayant servies à la réalisation des deuxièmes portions 114. Sur l'exemple de la figure 5, la deuxième portion 114.1 qui est disposée contre le substrat 102 comporte du SiGe avec une concentration en germanium égale à environ 40 %, la deuxième portion 114.2 suivante comporte du SiGe avec une concentration en germanium égale à environ 30 %, la deuxième portion 114.3 suivante comporte du SiGe avec une concentration en germanium égale à environ 20%, et la dernière deuxième portion 114.4 comporte du SiGe avec une concentration en germanium égale à environ 10 %.

Ces compositions et/ou concentrations différentes d'une portion de semi-conducteur à l'autre peuvent également s'appliquer aux semi-conducteurs des premières portions 112 (que les compositions et/ou concentrations des semi-conducteurs des deuxièmes portions 114 soient différentes ou non d'une deuxième portion 114 à l'autre). Dans tous les cas, ces compositions et/ou concentrations différentes au sein des semi-conducteurs des premières portions 112 et/ou des deuxièmes portions 114 ont un impact sur les compositions et/ou concentrations dans les semi-conducteurs des nanostructures 100. Ainsi, dans l'exemple de réalisation décrit en lien avec la figure 5, le semi-conducteur des nanostructures 100.1 comporte une concentration en germanium supérieure à celle du semi-conducteur des nanostructures 100.2. De même, le semi-conducteur des nanostructures 100.2 comporte une concentration en germanium supérieure à celle du semi-conducteur des nanostructures 100.3. Enfin, le semi-conducteur des nanostructures 100.3 comporte une concentration en germanium supérieure à celle du semi-conducteur des nanostructures 100.4. Cela est dû au fait que les atomes du semi-conducteur des nanostructures 100 proviennent majoritairement des deuxièmes portions 114 de semi-conducteur directement adjacentes aux premières portions 112 sur lesquelles les nanostructures 100 sont réalisées.

Il est également possible que les semi-conducteurs des différentes portions 112, 114 soient de nature différente les uns des autres. Par exemple, il est possible que la portion 114.1 comporte un semi-conducteur A, que la portion 112.1 comporte un semi-conducteur B différent de A, que la portion 114.2 comporte un semi-conducteur C différent de A et B, etc. Il est également possible d'avoir un empilement de type : portion 112.1 comprenant un semi-conducteur A, portion 114.1 comprenant un semi-conducteur B, portion 112.2 comprenant le semi-conducteur A, portion 114.2 comprenant un semi-conducteur C, portion 112.3 comprenant le semi-conducteur A, etc. L'empilement 111 peut comporter d'autres combinaisons de différents semi-conducteurs empilés les uns au-dessus.

De manière générale, la composition du semi-conducteur des nanostructures 100 est définie par la composition des semi-conducteurs de la ou des portions ou couches immédiatement adjacentes à la portion ou couche contre laquelle les nanostructures 100 sont formées.

En variante, il est possible que les premières portions 112 n'aient pas des épaisseurs similaires les unes des autres et/ou que les deuxièmes portions 114 n'aient pas des épaisseurs similaires les unes des autres. Par exemple, en utilisant des deuxièmes portions 114 d'épaisseurs différentes, ces portions 114 fournissent, lors du traitement thermique, des quantités différentes d'atomes de germanium, ce qui conduit à l'obtention de nanostructures 100 ayant des concentrations en germanium différentes les unes des autres du fait que les atomes de germanium migrent en surface vers les premières portions 112 adjacentes. Une variation de la concentration en atomes ayant migrés pour former les nanostructures 100 peut également être obtenue en utilisant des premières portions 112 ayant des épaisseurs différentes les unes des autres. Ainsi, en considérant deux premières portions 112 avec l'une plus épaisse que l'autre, recevant une même quantité d'atomes de germanium, la concentration en atomes de germanium sera moins importante dans la première portion 112 qui est la plus épaisse.

Le procédé de réalisation des nanostructures 100 peut être mis en œuvre à partir d'un empilement 111 de portions 112, 114 formant un ou plusieurs nano-dot, ou nano-point, lorsqu'une fonction de confinement quantique est destiné à être mise en œuvre au sein de cet empilement 111, ou bien à partir d'un empilement 111 de portions 112, 114 formant un ou plusieurs nanofils, par exemple lorsque cet empilement 111 est destiné à servir à la réalisation d'un transistor.

Le procédé décrit ci-dessus permettant de réaliser les nanostructures 100 est avantageusement mis en œuvre au cours de procédés de réalisation de dispositifs semi-conducteurs 200 correspondant avantageusement à des transistors de type GAA-FET ou bien encore des transistors SET. Toutefois, d'autres types de dispositifs, comme par exemple des dispositifs émissifs lumineux à base de semi-conducteurs III-V, peuvent être réalisés en faisant appel au procédé de réalisation décrit précédemment.

Un mode de réalisation du procédé entier de réalisation d'un dispositif semi-conducteur 200, correspondant ici à transistor GAA-FET, est décrit ci-dessous en lien avec les figures 6 à 11.

Le transistor 200 est réalisé à partir de l'empilement 104 de couches 106, 108, comprenant deux semi-conducteurs cristallins différents et disposé sur le substrat 102. Dans le mode de réalisation décrit ici, le substrat 102 correspond à un substrat massif, ou « bulk », de semi-conducteur, par exemple de silicium, sur lequel est disposé l'empilement comprenant les premières et deuxièmes couches 106, 108 de semi-conducteurs différents et disposées de manière alternée les unes au-dessus des autres. Chacune des premières couches 106 est destinée à servir à la réalisation d'un nanofil de semi-conducteur du canal du transistor 200, et est disposée entre deux deuxièmes couches 108 comportant un semi-conducteur qui est à la fois apte à être gravé sélectivement par rapport à celui des premières couches 106 ainsi que par rapport aux matériaux destinés à être utilisés par la suite pour former une grille factice et des espaceurs externes, et qui est également adapté pour former les nanostructures 100 par migration de surface comme précédemment décrit. Dans le mode de réalisation décrit ici, cet empilement comporte trois premières couches 106 et quatre deuxièmes couches 108 disposées de manière alternée telles que chacune des premières couches 106 soit disposée entre deux deuxièmes couches 108.

Les matériaux des premières et deuxièmes couches 106, 108 correspondent à des premiers et deuxièmes semi-conducteurs cristallins pouvant être formés par épitaxie sur le substrat 102. Dans l'exemple décrit ici, le substrat 102 et les premières couches 106 comportent du silicium et les deuxièmes couches 108 comportent du SiGe avec une proportion de germanium par exemple comprise entre environ 35 % (Si_{0,65}Ge_{0,35}) et 50 % (Si_{0,5}Ge_{0,5}).

En variante, le substrat utilisé pour former l'empilement 104 peut correspondre à un substrat SOI (silicium sur isolant), avec dans ce cas la couche superficielle, ou couche mince, du substrat SOI qui peut former l'une des deuxièmes couches 108 de l'empilement. Lorsque les deuxièmes couches 108 comportent du SiGe, un enrichissement de Ge peut être réalisé dans le silicium de la couche superficielle afin de transformer ce silicium en SiGe, formant ainsi un substrat SiGeOI.

De manière avantageuse, le substrat 104 et les premières et deuxièmes couches 106, 108 de l'empilement sont adaptées pour réaliser des transistors de type P. Des transistors de type N peuvent toutefois être réalisés avec la mise en œuvre de ce procédé.

L'empilement 104 comprenant les premières et deuxièmes couches 106, 108 est gravé sous la forme d'une portion allongée telle que représentée sur la figure 6, et formant l'empilement 111 des premières et deuxièmes portions 112, 114 disposées sur le substrat 102. Les portions 112, 114 correspondent ici à des nanofils. Lorsque plusieurs transistors 200 sont réalisés collectivement à partir du même empilement 104, plusieurs empilements 111 sont réalisés sur le substrat 102.

Les premières portions 112 issues des premières couches 106 forment des premiers nanofils du premier semi-conducteur et les deuxièmes portions 114 issues des deuxièmes couches 108 forment des deuxièmes nanofils du deuxième semi-conducteur. Sur l'exemple de la figure 6, l'empilement 111 comporte trois premiers nanofils, ou trois premières portions, 112, chacun disposé entre deux deuxièmes nanofils, ou deux deuxièmes portions, 114.

La largeur de l'empilement 111, qui correspond à sa dimension selon l'axe Y représenté sur la figure 6, est égale à la largeur souhaitée des premières portions 112 destinées à la réalisation du canal du transistor 200.

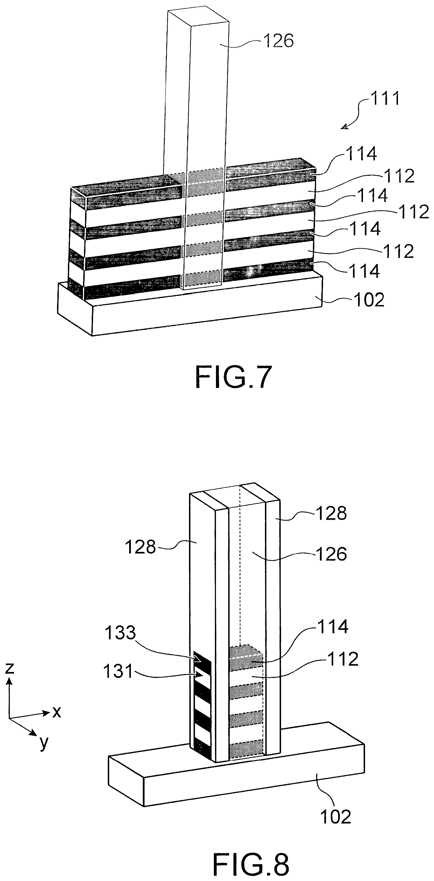

Une grille factice 126, ou grille temporaire, est ensuite réalisée, par exemple par lithographie et gravure, sur l'empilement 111, à l'emplacement destiné à la future grille définitive du transistor 200 (figure 7). La grille factice 126 est formée sur des parties des premières portions 112 destinées à former le canal du dispositif 100, ainsi que sur des parties des deuxièmes portions 114 entre lesquelles se trouvent ces parties des premières portions 112, et recouvre également des flancs latéraux des premières et deuxièmes portions 112, 114 de l'empilement 111.

Des espaceurs externes 128 sont ensuite réalisés, par exemple par dépôt et gravure, sur l'empilement 111, et contre des flancs latéraux de la grille factice 126 (figure 8). La longueur, ou profondeur, de ces espaceurs externes 128 (dimension parallèle à l'axe X représenté sur la figure 8) est par exemple comprise entre environ 3 et 12 nm. Les espaceurs externes 128 sont destinés à isoler la future grille du transistor 200 vis-à-vis des régions de source et drain qui seront réalisées.

La grille factice 126 comporte par exemple du silicium amorphe ou polycristallin, et les espaceurs externes 128 comportent par exemple du SiN et/ou du Si₃N₄ et/ou du SiBCN.

Les parties de l'empilement 111 non recouvertes par la grille factice 126 et par les espaceurs externes 128 sont ensuite gravées (figure 8), par exemple lors de la gravure des espaceurs externes 128. Des parties restantes des premières portions 112 sont destinées à former le canal du dispositif 100. Chacune des parties restantes des premières portions 112 est interposée entre deux parties restantes des deuxièmes portions 114. Les extrémités de ces parties restantes, référencées 131 pour les parties restantes des premières portions 112 et référencées 133 pour les parties restantes des deuxièmes portions 114, sont accessibles de chaque côté des espaceurs externes 128.

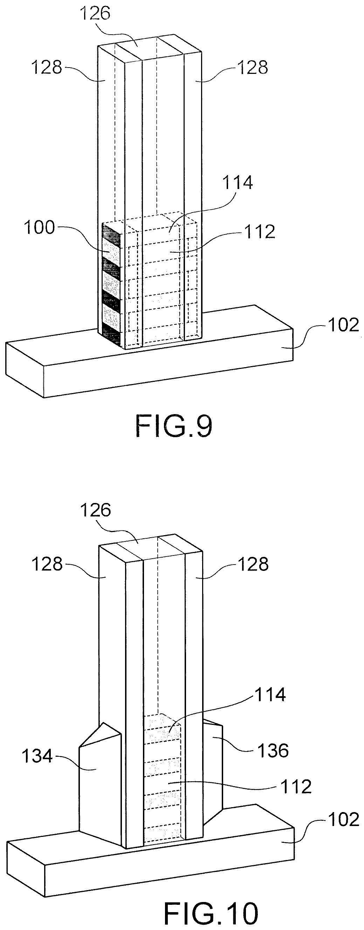

A partir de l'empilement 111, un traitement thermique est mis en œuvre afin de former les nanostructures 100 au niveau des extrémités 131 des parties restantes des premières portions 112. Des atomes de germanium du SiGe des parties restantes des deuxièmes portions 114 migrent vers la surface des extrémités 131, formant les nanostructures 100 au niveau de ces extrémités 131 (figure 9).

Comme représenté sur la figure 10, des régions de source et drain 134, 136 sont ensuite réalisées par épitaxie sur le substrat 102, depuis les nanostructures 100 et les extrémités 133 des parties restantes des deuxièmes potions 114 (et du substrat 102 lorsqu'il comporte un semi-conducteur cristallin à partir duquel une épitaxie peut être réalisée). Ces régions de source et de drain 134, 136 sont en contact direct avec les nanostructures 100. Afin que les régions de source et de drain 134, 136 résistent à la gravure qui est mise en œuvre ensuite pour supprimer les parties restantes 132 qui comportent ici du SiGe, ces régions de source et de drain 134, 136 comportent par exemple du silicium dopé avec des atomes de bore (cas d'un transistor de type P) ou avec des atomes de phosphore (cas d'un transistor de type N).

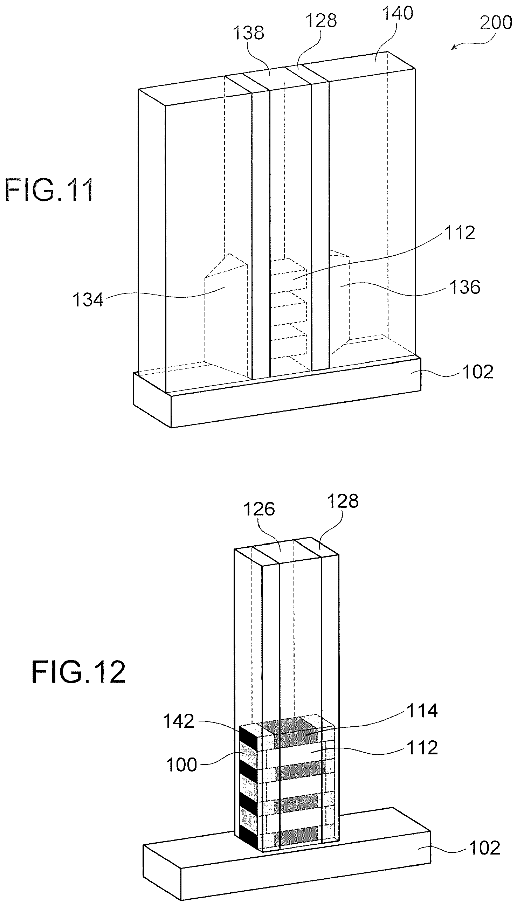

Le transistor 200 est achevé en supprimant la grille factice 126, en supprimant les parties restantes des deuxièmes portions 114 via une gravure sélective vis-à-vis des autres semi-conducteurs présents, et en formant la grille définitive 138 via le dépôt d'un diélectrique de grille (par exemple de type « high-k », ou forte permittivité diélectrique, c'est-à-dire supérieure à environ 3,9) et d'un matériau conducteur de grille dans l'emplacement libéré par la gravure de la grille factice 126, notamment autour des parties restantes des premières portions 112 formant le canal du transistor 200 (figure 11). Les nanostructures 100 se retrouvent disposées entre les parties restantes des premières portions 112 formant le canal du transistor 200 et les régions de source et de drain 134, 136. Un matériau d'encapsulation 140 est en outre déposé en recouvrant notamment les régions de source et de drain 134, 136. Selon une réalisation particulière, les dimensions des nanostructures 100 peuvent être telles qu'elles soient en partie recouvertes par la grille 138.

Dans ce procédé de réalisation de transistor 200 décrit ci-dessus, aucun espaceur interne n'est réalisé entre la grille 138 et les régions de source et de drain 134, 136.

Selon un autre mode de réalisation du procédé de réalisation du transistor 200, de tels espaceurs internes peuvent être réalisés comme cela est décrit ci-dessous.

Dans cet autre mode de réalisation, les étapes précédemment décrites en lien avec les figures 6 à 9 sont mises en œuvre. Les extrémités 133 des parties restantes des deuxièmes portions 114 de SiGe sont ensuite gravées sélectivement, notamment vis-à-vis des nanostructures 100 qui peuvent comporter par exemple une concentration en germanium moins importante que le semi-conducteur des deuxièmes portions 114. Cette gravure forme des cavités de profondeur par exemple comprise entre environ 2 nm et 10 nm.

Ces cavités sont ensuite remplies de matériau diélectrique formant des espaceurs internes 142 (figure 12). Ce matériau diélectrique, par exemple du SiN, et déposé dans les cavités, et le surplus de matériau diélectrique se trouvant en dehors des cavités est retiré, par exemple en mettant en œuvre un nettoyage sélectif par du H₃PO₄ lorsque le matériau diélectrique comporte un nitrure. Le procédé est ensuite achevé comme décrit précédemment pour le premier procédé, c'est-à-dire en réalisant les régions de source et de drain 134, 136, en supprimant la grille factice 126 ainsi que les parties restantes 132, en réalisant la grille définitive 138 et en déposant le matériau d'encapsulation 140.

Selon une variante de ce procédé, il est possible de graver les extrémités 133 des deuxièmes portions 114 de SiGe avant de former les nanostructures 100. Les nanostructures 100 sont ensuite réalisées, puis les espaceurs internes 142 sont réalisés (ou inversement). Le procédé est ensuite achevé comme décrit précédemment.

La réalisation de nanostructures 100 au sein du transistor 200 peut également servir à améliorer les jonctions entre le canal et les régions de source et de drain. En effet, dans un transistor GAA-FET tel que celui obtenu en mettant en œuvre le deuxième procédé décrit ci-dessus, c'est-à-dire muni d'espaceurs internes, mais ne comportant pas les nanostructures 100, les portions de semi-conducteur se trouvant entre le canal et les régions de source et de drain, sous les espaceurs externes, ne sont pas dopées. Un recuit permettant la migration de dopants depuis les régions de source et de drain vers ces portions de semi-conducteur destinées à former des régions d'extension de résistance électrique réduite est généralement mis en œuvre. Un tel recuit ne permet toutefois pas d'obtenir une jonction bien définie géométriquement.

Un procédé de réalisation de transistor 200 selon un autre exemple non-revendiqué mais utile à la compréhension de l'invention est décrit ci-dessous, répondant notamment au problème exposé précédemment.

La structure intermédiaire représentée sur la figure 12 est tout d'abord réalisée comme précédemment décrit, c'est-à-dire comprenant l'empilement des portions restantes des premières et deuxièmes portions 112, 114 disposées sur le substrat 102, les espaceurs internes 142, les nanostructures 100, les espaceurs externes 128 et la grille factice 126.

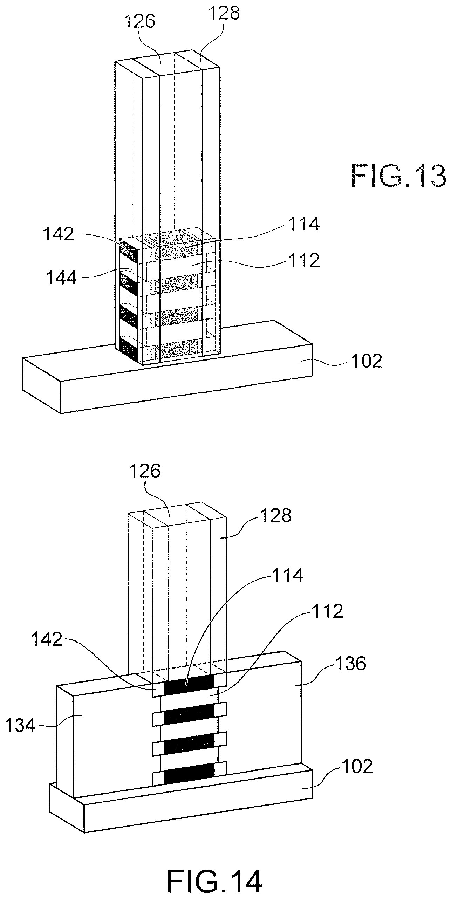

Les nanostructures 100 sont ensuite gravées sélectivement vis-à-vis des autres semi-conducteurs, formant des cavités 144 aux emplacements précédemment occupés par les nanostructures 100, entre les espaceurs internes 142 (figure 13). Les régions de source et de drain 134, 136 sont ensuite réalisées, comme représenté sur la figure 14. Une partie du semi-conducteur des régions de source et de drain 134, 136 est notamment disposée dans les cavités 144. Le transistor 200 est ensuite achevé comme décrit précédemment, c'est-à-dire en supprimant la grille factice 126 ainsi que les parties restantes des deuxièmes portions 114, en réalisant la grille définitive 138 et en déposant le matériau d'encapsulation 140.

Du fait que, lors de la réalisation des nanostructures 100, les dimensions des nanostructures 100 sont bien contrôlées, les dimensions des cavités 144 le sont également. Dans ce procédé, ce bon contrôle des dimensions des nanostructures 100 est utilisé notamment pour réaliser les nanostructures 100 telles que les cavités 144 aient une profondeur (dimension selon l'axe X représenté sur la figure 13) inférieure à celle des espaceurs internes 142, c'est-à-dire tel qu'une région des parties restantes des premières portions 112 soit disposée contre les espaceurs internes 142. Cela est difficilement réalisable en l'absence des nanostructures 100, c'est-à-dire en gravant directement les parties restantes des premières portions 112 depuis leurs extrémités. Or, si les régions de source et de drain 134, 136 comportent un semi-conducteur similaire à celui des deuxièmes portions 114 destinées à être gravées, il est difficile de graver ces deuxièmes portions 114 sans endommager les parties des régions de source et de drain 134, 136 se trouvant à proximité des deuxièmes portions 114.

Les différents procédés précédemment décrits peuvent être mis en œuvre pour réaliser des transistors de type N ou P.

Un autre problème pouvant être résolu grâce aux nanostructures 100 est que dans un transistor GAA-FET tel que celui obtenu en mettant en œuvre le deuxième procédé décrit ci-dessus, c'est-à-dire muni d'espaceurs internes, mais ne comportant les nanostructures 100, les portions de semi-conducteur se trouvant entre le canal et les régions de source et de drain, sous les espaceurs externes, ne sont pas dopées. Un recuit permettant la migration de dopants depuis les régions de source et de drain vers ces portions de semi-conducteur destinées à former des régions d'extension de résistance électrique réduite est généralement mis en œuvre. Outre les problèmes précédemment mentionnés liés à la mise en œuvre d'un tel recuit, et dans le cas d'un transistor de type P, les dopants utilisés tels que le Bore ont une forte diffusivité, ce qui peut entrainer une migration de ces dopants jusque dans le canal, réduisant ainsi les performances du transistor.

Un procédé de réalisation de transistor 200 selon un autre exemple non-revendiqué mais utile à la compréhension de l'invention est décrit ci-dessous, répondant notamment au problème exposé précédemment.

La structure intermédiaire représentée sur la figure 12 est tout d'abord réalisée comme précédemment décrit, c'est-à-dire comprenant l'empilement des parties restantes des premières et deuxièmes portions 112, 114 disposées sur le substrat 102, les espaceurs internes 142, les nanostructures 100, les espaceurs externes 128 et la grille factice 126.

Les régions de source et de drain 134, 136 dopées au bore sont ensuite réalisées par épitaxie en conservant les nanostructures 100 qui comprennent par exemple du SiGe, entre les parties restantes des premières portions 112 formant le canal du transistor 200 et les régions de source et de drain 134, 136.

Etant donné que la diffusion du Bore dans le SiGe est plus lente que dans le silicium, les nanostructures 100 forment une barrière à ces dopants et évitent leur diffusion dans le canal du transistor 200 lors du recuit d'activation de ces dopants du fait que les atomes de bore s'accumulent dans les nanostructures 100 en raison de leur composition différente (le SiGe étant apte à être plus concentré en atomes dopants que du silicium).

La réalisation de nanostructures 100 par migration de surface d'atomes de semi-conducteur peut également servir à la réalisation d'éléments d'arrêt de gravure destinés à protéger le semi-conducteur des régions de source et de drain.

Un procédé selon un autre exemple non-revendiqué mais utile à la compréhension de l'invention et formant le transistor 200 dans lequel les espaceurs internes correspondent à des nanostructures 100 formées par migration de surface d'atomes de semi-conducteur est décrit ci-dessous.

Les étapes précédemment décrites en lien avec les figures 6 à 8 sont tout d'abord mises en œuvre, à la différence toutefois que l'empilement initial 104 est réalisé tel qu'ensuite, chacune des deuxièmes portions 114 est disposée entre deux premières portions 112 du fait que les deuxièmes portions 114 comportant du SiGe sont ici destinées à former le canal du transistor 200.

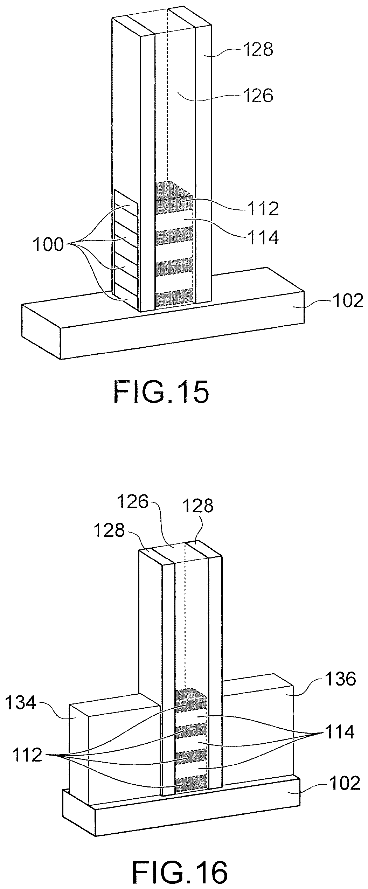

Un recuit est ensuite mis en œuvre à une température engendrant une migration de surface des atomes de germanium des parties restantes des deuxièmes portions 114 vers les extrémités des parties restantes des premières portions 112, formant les nanostructures 100 aux extrémités des parties restantes des premières portions 112 (figure 15).

Comme représenté sur la figure 16, les régions de source et de drain 134, 136 sont ensuite réalisées par épitaxie de silicium, et par exemple dopé au bore dans le cas d'un transistor 200 de type P.

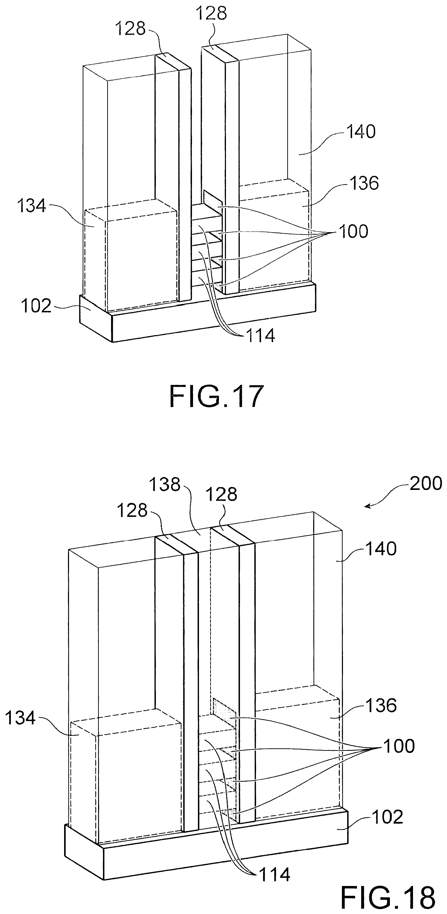

Le matériau d'encapsulation 140 est ensuite formé sur les régions de source et de drain 134, 136, puis la grille factice 126 est supprimée par gravure. Les parties restantes des premières portions 112 sont également supprimées par gravure sélective vis-à-vis des parties restantes des deuxièmes portions 114 comprenant du SiGe (figure 17). Lors de cette gravure, les nanostructures 100 servent à arrêter l'agent de gravure et à protéger les régions de source et de drain 134, 136.

Comme représenté sur la figure 18, le transistor 200 est ensuite achevé en réalisant la grille définitive 138, comme précédemment décrit pour les autres procédés de réalisation, en entourant les parties restantes des deuxièmes portions 114 formant le canal du transistor 200.

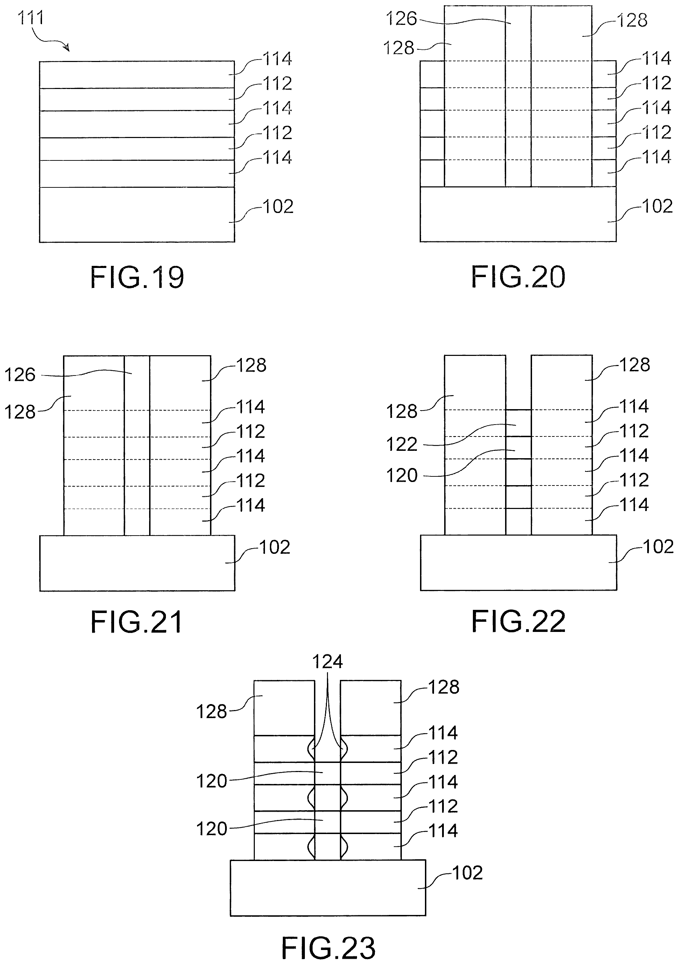

Un procédé de réalisation du dispositif semi-conducteur 200 selon un autre exemple non-revendiqué mais utile à la compréhension de l'invention est décrit ci-dessous en lien avec les figures 19 à 28.

Comme représenté sur la figure 19, l'empilement 111 comprenant les premières portions 112 du premier semi-conducteur (ici du silicium) et les deuxièmes portions 114 du deuxième semi-conducteur (ici du SiGe avec par exemple une concentration en germanium égale à environ 50 %) est tout d'abord réalisé. Cet empilement 111 peut être obtenu comme précédemment décrit, c'est-à-dire à partir d'une gravure d'un empilement de couches alternées Si / SiGe.

La grille factice 126 et les espaceurs externes 128 sont ensuite réalisés sur l'empilement 111 (figure 20).

L'empilement 111 est ensuite gravé afin de ne conserver que les parties de l'empilement 111 recouvertes par la grille factice 126 et les espaceurs externes 128 (figure 21).

La grille factice 126 est ensuite retirée (figure 22). Avec ce retrait de la grille factice, des régions 120 des premières portions 112 précédemment recouvertes par la grille factice 126 et non recouvertes par les espaceurs externes 128 sont révélées et accessibles. De mêmes, des régions 122 des deuxièmes portions 114 précédemment recouvertes par la grille factice 126 et non recouvertes par les espaceurs externes 128 sont révélées par ce retrait et sont accessibles.

Une gravure sélective du deuxième semi-conducteur (ici le SiGe) vis-à-vis du premier semi-conducteur (ici le Si) est ensuite mise en œuvre pour supprimer les régions 122 exposées des deuxièmes portions 114. Cette gravure est par exemple réalisée en utilisant du H₂O₂. Outre la suppression des régions 122, cette gravure forme également des creux, ou cavités, 124, dans les parties des deuxièmes portions 114 recouvertes par les espaceurs externes 128, au niveau des flancs latéraux se trouvant du côté de l'emplacement de la grille. Au niveau de l'emplacement de la grille, seules les régions 120 des premières portions 112 sont conservées.

Un traitement thermique est ensuite mis en œuvre afin d'engendrer la migration d'atomes depuis les parties des deuxièmes portions 114 recouvertes par les espaceurs externes 128 jusque dans les régions 120 des premières portions 112. Les paramètres de mise en œuvre du traitement thermique sont similaires à ceux décrits dans les précédents exemples et modes de réalisation. Les nanostructures 100 obtenues correspondent à des îlots quantiques de SiGe dont la concentration est germanium est inférieure à celle du SiGe des deuxièmes portions 114. La forme, la disposition et les dimensions des nanostructures 100 sont donc prédéfinies via le choix de l'épaisseur initiales des couches de silicium desquelles sont issues les premières portions 112, de la forme des première portions 112 et des dimensions de la grille factice 126.

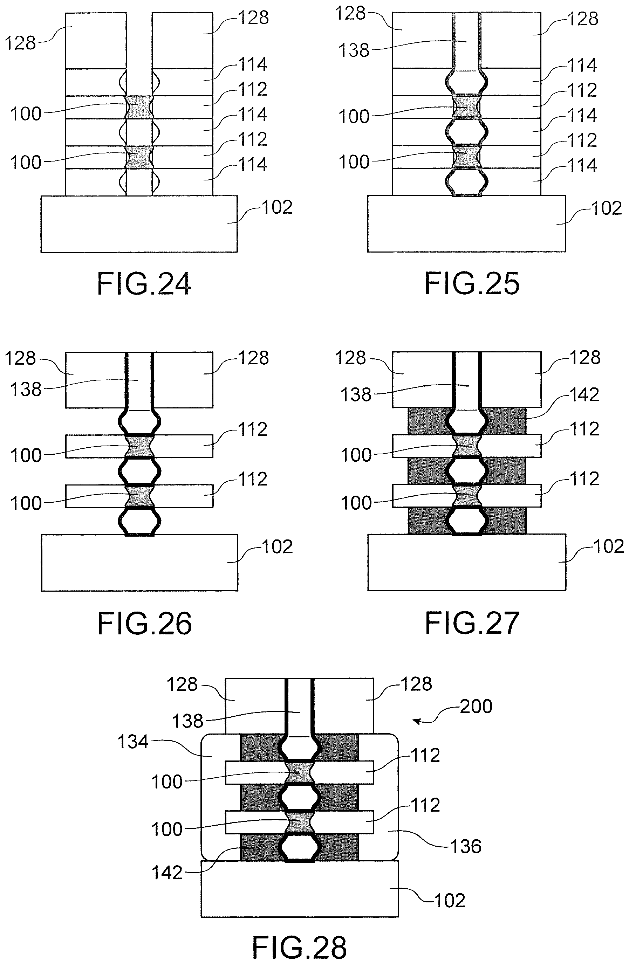

La grille 138 est ensuite réalisée dans l'emplacement libéré par la gravure de la grille factice 126, entourant ainsi les îlots quantiques formés par les nanostructures 100 (figure 25).

Les parties restantes des deuxièmes portions 114 sont ensuite gravées de manière sélective vis-à-vis des premières portions 112 (figure 26).

Les espaceurs internes 142 sont ensuite réalisés dans les emplacements formés à l'étape précédente par la gravure des parties restantes des deuxièmes portions 114, sous les espaceurs externes 128 (figure 27).

Le transistor SET 200 est ensuite achevé en formant les régions de source et de drain en semi-conducteur dopé par épitaxie depuis les extrémités des premières portions 112 (figure 28).

Dans le transistor SET 200 ainsi réalisé, le canal est formé par les îlots quantiques de SiGe correspondant aux nanostructures 100 superposées les unes au-dessus des autres. Des barrières à blocage de Coulomb du transistor SET 200 sont formées par les parties restantes des premières portions 112 comportant le premier-semi-conducteur non dopé et qui permettent le passage des porteurs de charges de manière unitaire dans les nanostructures 100, ce passage des porteurs de charge étant contrôlé par la grille 138.

## Revendications

1. Procédé de réalisation d'un dispositif semi-conducteur (200) comprenant au moins la mise en œuvre des étapes suivantes :
- réalisation, sur un substrat (102), d'au moins un empilement (111) comprenant au moins une alternance formée d'une première portion (112) d'un premier semi-conducteur entre deux deuxièmes portions (114) d'un deuxième semi-conducteur différent du premier semi-conducteur et apte à être gravé sélectivement vis-à-vis du premier semi-conducteur, tel que l'épaisseur d'au moins la première portion (112) soit sensiblement égale à l'épaisseur de nanostructures (100) destinées à être réalisées ;
- réalisation, sur une partie de l'empilement (111), d'espaceurs externes (128) et d'au moins une grille factice (126) disposée entre les espaceurs externes (128),
- gravure de l'empilement (111) tel que des parties restantes des première et deuxièmes portions (112, 114) soient seulement disposées sous la grille factice (126) et sous les espaceurs externes (128) et forment un empilement de nanofils,
- traitement thermique de l'empilement (111) à une température engendrant au moins une migration d'atomes du deuxième semi-conducteur des surfaces libres des parties restantes des deuxièmes portions (114) vers des surfaces libres d'au moins une partie restante de ladite au moins une première portion (112), correspondant à des extrémités (131) de ladite au moins une partie restante de ladite au moins une première portion (112) et au niveau desquelles se forment des nanostructures (100) comprenant au moins des atomes du deuxième semi-conducteur,
- réalisation de régions de source et de drain (134, 136) par épitaxie de semi-conducteur depuis au moins les nanostructures (100), et telles que le deuxième semi-conducteur soit apte à être gravé sélectivement vis-à-vis du semi-conducteur des régions de source et de drain (134, 136),
- suppression de la grille factice (126) et de la partie restante de la deuxième portion (114),
- réalisation d'une grille (138) entre les espaceurs externes (128) et entourant au moins un canal du dispositif semi-conducteur (200) formé par ladite au moins une partie restante de ladite au moins une première portion (112).

2. Procédé selon la revendication 1, dans lequel :
- le premier semi-conducteur comporte du Si, et/ou
- le deuxième semi-conducteur comporte du Ge, et/ou
- la température du traitement thermique est comprise entre environ 750°C et 850°C, et/ou
- le traitement thermique est mis en œuvre dans une atmosphère contenant de l'hydrogène.

3. Procédé selon la revendication 2, dans lequel le deuxième semi-conducteur comporte du SiGe ayant une concentration en germanium comprise entre environ 20 % et 80%.

4. Procédé selon l'une des revendications précédentes, dans lequel l'épaisseur de la première portion (112) est comprise entre environ 4 nm et 20 nm.

5. Procédé selon l'une des revendications précédentes, dans lequel l'empilement (111) est une alternance de plusieurs premières et deuxièmes portions (112, 114), et dans lequel la mise en œuvre du traitement thermique engendre au moins une migration d'atomes du deuxième semi-conducteur des surfaces libres des parties restantes des deuxièmes portions (114) vers les surfaces libres des parties restantes (116, 120, 131) des premières portions (112) au niveau de chacune desquelles se forme au moins une nanostructure (100) comprenant au moins des atomes du deuxième semi-conducteur.

6. Procédé selon la revendication 5, dans lequel plusieurs des deuxièmes portions (114) comportent des deuxièmes semi-conducteurs de compositions et/ou de concentrations atomiques différentes les unes des autres, formant des nanostructures (100) comprenant des semi-conducteurs différents.

7. Procédé selon la revendication 6, dans lequel chaque deuxième portion (114) comporte du SiGe ayant une concentration en germanium différente de celle du SiGe des autres deuxièmes portions (114).

8. Procédé selon l'une des revendications 5 à 7, dans lequel plusieurs des premières portions (112) comportent des épaisseurs différentes les unes des autres, et/ou plusieurs des deuxièmes portions (114) comportent des épaisseurs différentes les unes des autres.

9. Procédé selon l'une des revendications précédentes, dans lequel le semi-conducteur des régions de source et de drain (134, 136) est du silicium dopé.

10. Procédé selon l'une des revendications précédentes, comportant en outre, entre l'étape de traitement thermique de l'empilement (111) et l'étape de réalisation des régions de source et de drain (134, 136), la mise en œuvre des étapes suivantes :
- gravure partielle de la partie restante des deuxièmes portions (114) depuis des extrémités (133) de la partie restante des deuxièmes portions (114) révélées par la gravure de l'empilement (111), formant des cavités disposées au moins sous les espaceurs externes (128),
- réalisation d'espaceurs internes (142) dans les cavités après la mise en œuvre du traitement thermique.

11. Procédé selon l'une des revendications 1 à 10, dans lequel :
- le procédé comporte en outre, entre l'étape de réalisation des régions de source et de drain (134, 136) et l'étape de suppression de la grille factice (126) et de la partie restante des deuxièmes portions (114), la mise en œuvre d'un dopage du semi-conducteur des régions de source et de drain (134, 136), puis d'un recuit diffusant des dopants dans le semi-conducteur des régions de source et de drain (134, 136), ou
- l'étape de réalisation des régions de source et de drain (134, 136) est mise en œuvre telle que le semi-conducteur des régions de source et de drain (134, 136) soit dopé.

## Patentansprüche

1. Herstellungsverfahren einer Halbleitervorrichtung (200), umfassend wenigstens die Umsetzung folgender Schritte:
- Ausführen, auf einem Substrat (102), wenigstens einer Schichtung (111), die wenigstens eine Wechsellagerung umfasst, die von einem ersten Abschnitt (112) eines ersten Halbleiters zwischen zwei zweiten Abschnitten (114) eines zweiten Halbleiters gebildet wird, der von dem ersten Halbleiter verschieden und geeignet ist, gegenüber dem ersten Halbleiter selektiv geätzt zu werden, sodass die Dicke wenigstens des ersten Abschnitts (112) im Wesentlichen gleich ist wie die Dicke von Nanostrukturen (100), die dazu bestimmt sind, ausgeführt zu werden;
- Ausführen, auf einem Teil der Schichtung (111), von externen Abstandshaltern (128) und von wenigstens einer Gitterattrappe (126), die zwischen den externen Abstandshaltern (128) angeordnet ist,
- Ätzen der Schichtung (111), sodass übrige Teile der ersten und zweiten Abschnitte (112, 114) nur unter der Gitterattrappe (126) und unter den externen Abstandshaltern (128) angeordnet sind und eine Schichtung von Nanodrähten bilden,
- Wärmebehandeln der Schichtung (111) bei einer Temperatur, die wenigstens eine Migration von Atomen des zweiten Halbleiters der freien Oberflächen der übrigen Teile der zweiten Abschnitte (114) zu den freien Oberflächen wenigstens eines übrigen Teils des wenigstens einen ersten Abschnitts (112) hervorruft, die Extremitäten (131) des wenigstens einen übrigen Teils des wenigstens einen ersten Abschnitts (112) entsprechen und auf deren Höhe sich Nanostrukturen (100) bilden, die wenigstens Atome des zweiten Halbleiters umfassen,
- Ausführen von Source- und Drain-Bereichen (134, 136) durch Epitaxie eines Halbleiters aus wenigstens den Nanostrukturen (100), und sodass der zweite Halbleiter geeignet ist, gegenüber dem Halbleiter der Source- und Drain-Bereiche (134, 136) selektiv geätzt zu werden,
- Entfernen der Gitterattrappe (126) und des übrigen Teils des zweiten Abschnitts (114),
- Ausführen eines Gitters (138) zwischen den externen Abstandshaltern (128), das wenigstens einen Kanal der Halbleitervorrichtung (200) umgibt, die von dem wenigstens einen übrigen Teil des wenigstens einen ersten Abschnitts (112) gebildet wird.

2. Verfahren nach Anspruch 1, wobei:
- der erste Halbleiter Si umfasst und/oder
- der zweite Halbleiter Ge umfasst und/oder
- die Temperatur der Wärmebehandlung zwischen ungefähr 750°C und 850°C beträgt und/oder
- die Wärmebehandlung in einer wasserstoffhaltigen Atmosphäre umgesetzt wird.

3. Verfahren nach Anspruch 2, wobei der zweite Halbleiter SiGe mit einer Germaniumkonzentration, die zwischen ungefähr 20 % und 80 % beträgt, umfasst.

4. Verfahren nach einem der vorstehenden Ansprüche, wobei die Dicke des ersten Abschnitts (112) zwischen ungefähr 4 nm und 20 nm beträgt.

5. Verfahren nach einem der vorstehenden Ansprüche, wobei die Schichtung (111) eine Wechsellagerung von mehreren ersten und zweiten Abschnitten (112, 114) ist und wobei die Umsetzung der Wärmebehandlung wenigstens eine Migration von Atomen des zweiten Halbleiters der freien Oberflächen der übrigen Teile der zweiten Abschnitte (114) zu den freien Oberflächen der übrigen Teile (116, 120, 131) der ersten Abschnitte (112) hervorruft, auf deren Höhe sich jeweils wenigstens eine Nanostruktur (100) bildet, die wenigstens Atome des zweiten Halbleiters umfasst.

6. Verfahren nach Anspruch 5, wobei mehrere zweite Abschnitte (114) zweite Halbleiter mit Zusammensetzungen und/oder Atomkonzentrationen, die voneinander verschieden sind, umfassen, wodurch Nanostrukturen (100) gebildet werden, die verschiedene Halbleiter umfassen.

7. Verfahren nach Anspruch 6, wobei jeder zweite Abschnitt (114) SiGe mit einer Germaniumkonzentration umfasst, die von jener des SiGe der anderen zweiten Abschnitte (114) verschieden ist.

8. Verfahren nach einem der Ansprüche 5 bis 7, wobei mehrere der ersten Abschnitte (112) voneinander verschiedene Dicken umfassen und/oder mehrere der zweiten Abschnitte (114) voneinander verschiedene Dicken umfassen.

9. Verfahren nach einem der vorstehenden Ansprüche, wobei der Halbleiter der Source- und Drain-Bereiche (134, 136) dotiertes Silizium ist.

10. Verfahren nach einem der vorstehenden Ansprüche, weiter umfassend zwischen dem Schritt des Wärmebehandelns der Schichtung (111) und dem Schritt des Ausführens der Source- und Drain-Bereiche (134, 136) das Umsetzen folgender Schritte:
- teilweises Ätzen des übrigen Teils der zweiten Abschnitte (114) ausgehend von den Extremitäten (133) des übrigen Teils der zweiten Abschnitte (114), die durch das Ätzen der Schichtung (111) offengelegt wurden, wodurch Kavitäten gebildet werden, die wenigstens unter den externen Abstandshaltern (128) angeordnet sind,
- Ausführen von internen Abstandshaltern (142) in den Kavitäten nach Umsetzen der Wärmebehandlung.

11. Verfahren nach einem der Ansprüche 1 bis 10, wobei:
- das Verfahren weiter zwischen dem Schritt des Ausführens der Source- und Drain-Bereiche (134, 136) und dem Schritt des Entfernens der Gitterattrappe (126) und des übrigen Teils der zweiten Abschnitte (114) das Umsetzen einer Dotierung des Halbleiters der Source- und Drain-Bereiche (134, 136), dann ein Glühen zum Verteilen der Dotierungsstoffe in dem Halbleiter der Source- und Drain-Bereiche (134, 136) umfasst, oder
- der Schritt des Ausführens der Source- und Drain-Bereiche (134, 136) so umgesetzt wird, dass der Halbleiter der Source- und Drain-Bereiche (134, 136) dotiert wird.

## Claims

1. Method of fabrication of a semiconductor device (200) including at least the implementation of the following steps:
- fabrication, on a substrate (202), of at least one stack (111) comprising at least one alternating formed of a first portion (112) of a first semiconductor between two second portions (114) of a second semiconductor which is different from the first semiconductor and capable of being selectively etched relative to the first semiconductor, such that the thickness of at least the first portion (112) is substantially equal to the thickness of nanostructures (100) intended to be made;
- fabrication, on a part of the stack (111), of external spacers (128) and of at least one dummy gate (126) arranged between the external spacers (128),
- etching of the stack (111) such that remaining parts of the first and second portions (112, 114) are only arranged beneath the dummy gate (126) and beneath the external spacers (128) and form a stack of nanowires,
- thermal treatment of the stack (111) at a temperature which causes at least one migration of atoms of the second semiconductor of free surfaces of remaining parts of the second portions (114) towards free surfaces of at least one remaining part of said at least one first portion (112), corresponding to extremities (131) of said at least one remaining part of said at least one first portion (112) and at which nanostructures (100) comprising at least atoms of the second semiconductor,
- fabrication of source and drain regions (134, 136) by epitaxy of semiconductor from at least the nanostructures (100), and such that the second semiconductor is capable of being selectively etched relative to the semiconductor of the source and drain regions (134, 136),
- removal of the dummy gate (126) and of the remaining part of the second portion (114),
- fabrication of a gate (138) between the external spacers (128) and surrounding at least one channel of the semiconductor device (200) formed by said at least one remaining part of said at least one first portion (112).

2. Method according to claim 1, wherein:
- the first semiconductor comprises Si, and/or
- the second semiconductor comprises Ge, and/or
- the thermal treatment temperature is between about 750°C and 850°C, and/or
- the thermal treatment is carried out in an atmosphere containing hydrogen.

3. Method according to claim 2, wherein the second semiconductor comprises SiGe which has a germanium concentration between about 20% and 80%.

4. Method according to one of the preceding claims, wherein the thickness of the first portion (112) is between about 4 nm and 20 nm.

5. Method according to one of the preceding claims, wherein the stack (111) is an alternating of several first and second portions (112, 114), and wherein the implementation of the thermal treatment causes at least one migration of atoms of the second semiconductor of free surfaces of the remaining parts of the second portions (114) towards the free surfaces of the remaining parts (116, 120, 131) of the first portions (112) at each of which at least one nanostructure (100) comprising at least atoms of the second semiconductor is formed.

6. Method according to claim 5, wherein several of the second portions (114) comprise second semiconductors with different atomic compositions and/or different concentrations from one to another, forming nanostructures (100) which comprise different semiconductors.

7. Method according to claim 6, wherein each second portion (114) comprise SiGe which has a concentration of germanium which is different from that of the SiGe of other second portions (114).

8. Method according to one of claims 5 to 7, wherein several of the first portions (112) comprise different thicknesses from one to another, and/or several of the second portions (114) comprise different thicknesses from one to another.

9. Method according to one of the preceding claims, wherein the semiconductor of the source and drain region (134, 136) is doped silicon.

10. Method according to one of the preceding claims, further comprising, between the step of thermal treatment of the stack (111) and the source and drain regions (134, 136) fabrication step, the implementation of the following steps:
- partial etching of the remaining part of the second portions (114) from the extremities (133) of the remaining part of the second portions (114) revealed by the etching of the stack (111), forming cavities arranged at least beneath the external spacers (128),
- fabrication of internal spacers (142) within the cavities after the implementation of the thermal treatment.

11. Method according to one of claims 1 to 10, wherein:
- the method further comprises, between the source and drain regions (134, 136) fabrication step and the step of removal of the dummy gate (126) and of the remaining part of the second portions (114), the implementation of a doping of the semiconductor of the source and drain regions (134, 136), then annealing which diffuses dopants into the semiconductor of the source and drain regions (134, 136), or
- the step for making the source and drain regions (134, 136) is implemented such that the semiconductor of the source and drain regions (134, 136) is doped.
